Europäisches Patentamt

**European Patent Office**

**Office européen des brevets**

(19)

(11) Publication number: **0 063 837**
**A1**

## EUROPEAN PATENT APPLICATION

(21) Application number: **82200449.5**

(22) Date of filing: **14.04.82**

(51) Int. Cl.³: **C 30 B 15/04**, C 30 B 15/20,
C 30 B 29/06

(30) Priority: **29.04.81 NL 8102102**

(43) Date of publication of application: **03.11.82**
**Bulletin 82/44**

(84) Designated Contracting States: **DE FR GB IT NL**

(71) Applicant: **N.V. Philips' Gloeilampenfabrieken,**
**Groenewoudseweg 1, NL-5621 BA Eindhoven (NL)**

(72) Inventor: **De Kock, Arie Jan Rudolf, c/o INT.**
**OCTROOIBUREAU B.V. Prof.Holstlaan 6, NL-5656 AA**
**Eindhoven (NL)**
Inventor: **Van de Wijgert, Willibrordus Maria, c/o INT.**
**OCTROOIBUREAU B.V. Prof. Holstlaan 6, NL-5656 AA**
**Eindhoven (NL)**

(74) Representative: **Klamer, Kornelis et al,**
**INTERNATIONAAL OCTROOIBUREAU B.V. Prof.**
**Holstlaan 6, NL-5656 AA Eindhoven (NL)**

(54) Method of drawing a silicon rod and semiconductor device manufactured from the silicon rod.

(57) The invention relates to a method of drawing a monocrystalline silicon rod 1 from a silicon melt 2 in a quartz crucible 3.

In order to keep the loss of oxygen from the melt as low as possible and to keep the oxygen content in the drawn rod as high as possible, the silicon rod 1 is drawn through an aperture 5 in a body 6 floating on the melt 2.

The aperture 5 is so large with respect to the diameter of the rod 1 that the shape of the meniscus 4 of the melt 2 around the rod 1 is not influenced by the body 6.

"Method of drawing a silicon rod and semiconductor
device manufactured from the silicon rod".

The invention relates to a method of drawing a
monocrystalline silicon rod from a silicon melt present in
a quartz crucible, and to a semiconductor device manufactured from the silicon rod.

Silicon slices which are used in the manufacture
of semiconductor devices are manufactured from monocrystalline silicon rods.

In the manufacture of semiconductor devices from
silicon slices, it is of great importance that undesired
impurities should occur as little as possible in the silicon.

It is known that undesired impurities, notably
metallic impurities, are gettered (gettered intrinsically)
by means of oxygen precipitates in the silicon slice.

These oxygen precipitates are formed during
thermal treatments of the slices, which treatments are
usual in the manufacture of semiconductor devices.
The oxygen required for this purpose is taken up during
drawing the silicon rod in the melt by reaction of the
molten silicon with the quartz crucible. The oxygen taken
up in the melt is incorporated in the crystallizing rod or
disappears as silicon monoxide by evaporation $\underline{via}$ the free
surface of the silicon melt.

It has been found that the oxygen content in a
drawn rod varies from approximately $10^{18}$ atoms per $cm^3$ at
the beginning near the seed up to approximately $5 \times 10^{17}$ atoms
per $cm^3$ at the tail end of the rod (measured by means of
infrared spectroscopy according to Kaiser and Keck,
J.Appl.Phys. $\underline{28}$, 882 (1957)), at which concentration no or
only a slight precipitation occurs. So in at this last-
mentioned oxygen concentration, hardly any gettering by
means of oxygen precipitation occurs any more. As a result
of the thus occurring variation in oxygen concentration
in the rod, important differences in quality may occur

0063837

between semiconductor devices which are manufactured from different slices.

It is therefore desirable to draw silicon rods with oxygen contents above that concentration at which oxygen precipitates start to occur to an important extent, i.e. above approximately $7 \times 10^{17}$ atoms per $cm^3$, preferably above $10^{18}$ atoms per $cm^3$. At most $2 \times 10^{18}$ atoms of oxygen per $cm^3$ can be incorporated in monocrystalline silicon.

One of the objects of the invention is to draw monocrystalline silicon rods with a concentration of oxygen in the silicon which is as homogeneous as possible and which can be controlled.

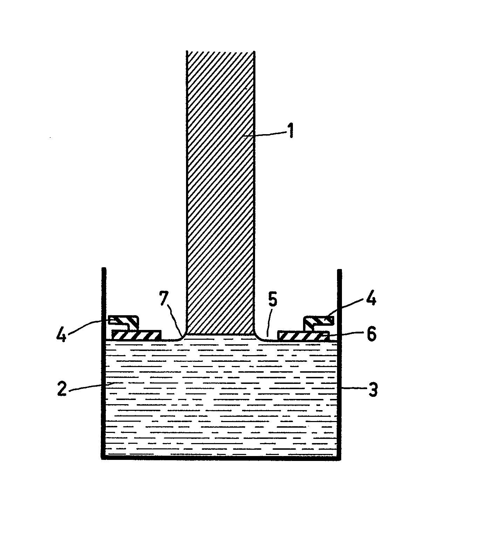

The variation in the content of oxygen in monocrystalline silicon rods is preferably associated with the fact that the crucible used in the drawing process has a cylindrical shape. As a result of this the contact area between the silicon melt and the crucible wall during drawing becomes smaller when the level of the silicon melt in the crucible drops, while the free surface of the silicon melt remains constant. As a result of this less oxygen will dissolve in the melt from the crucible wall, while the possibility of evaporation of silicon monoxide from the melt remains constant. The result is that during drawing an ever decreasing quantity of oxygen is incorporated in the rod.

The invention is based inter alia on the recognition of the fact that the important improvement as regards the magnitude of the oxygen content in the drawn rod can be obtained by reducing the free surface of the silicon melt in the crucible.

Therefore, the method mentioned in the opening paragraph is characterized according to the invention in that the silicon rod is drawn through an aperture in a body floating on the melt, the aperture being chosen to be so large with respect to the diameter of the silicon rod that the shape of the meniscus of the melt around the rod is not influenced by the body.

By means of the method according to the invention the concentration of oxygen in the silicon rod may be considerably increased with respect to known methods.

As regards the condition that the shape of the meniscus of the melt near the rod may not be influenced by the body it is to be noted that this condition is imposed so as to avoid dislocations as a result of such an influencing.

It is to be noted that it is known _per se_ to obtain non-circular rods, to draw a rod _via_ a non-circular aperture. As a result of the short distance between the edge of the aperture and the rod, the meniscus of the melt near the rod is influenced in such a manner that the rod assumes the shape of the aperture. In such a method it is substantially impossible to avoid the formation of dislocations.

The floating body preferably consists of quartz. The advantage of such a body is that oxygen can be given off to the melt also via the contact face between the melt and the body, and that also as a result of this the oxygen content in the melt near the aperture remains at a high level.

The method according to the invention can be carried out particularly easily when the body is a flat annulus.

In order to prevent the floating body from adhering to the wall of the crucible, the floating body preferably has pins extending beyond the circumference of the body and which keep the floating body free from the wall of the quartz crucible.

The invention furthermore relates to a semiconductor device manufactured from a silicon rod drawn by means of the method according to the invention. The influence of undesired impurities is considerably suppressed in such semiconductor devices.

An embodiment of the invention will now be described in greater detail with reference to an example and the accompanying drawing.

The drawing is a diagrammatic sectional view of a part of a device for carrying out the method according to the invention.

In this example, a monocrystalline silicon rod 1 is drawn from a silicon melt 2 present in a quartz crucible 3.

According to the invention, the silicon rod 1 is drawn through an aperture 5 in a body 6 floating on the melt 2, the body being preferably quartz. The aperture 5 is chosen to be so large with respect to the diameter of the silicon rod 1 that the shape of the meniscus 7 of the melt 2 around the rod 1 is not influenced by the quartz body 6.

The quartz body 6 is a flat annulus provided with three quartz pins 4 which extend beyond the circumference of the body 6 and keep the floating body 6 free from the wall of the quartz crucible 3.

In order to prevent deformation of the body 6, said body is contacted with the silicon only after said silicon has melted. The melt 2 is then contacted with a seed crystal.

For example, a rod 1 having a diameter between 3.5 and 4 cm is drawn, at a rate of 1.3 mm per minute, from a cylindrical crucible 3 having an inside diameter of 8.5 cm through a circular aperture 5 having a diameter of 6 cm in a 2 mm thick quartz body 6 having an outside diameter of 8 cm which floats on the silicon melt 2.

The melt 2 is constantly stirred thoroughly by rotating the rod 1 and the crucible 3 in opposite directions. The growth takes place in argon at a pressure of 1 atmosphere. The aperture 5 is sufficiently large for a conventional automatic diameter control by means of reflection at the meniscus.

As a result of the presence of a floating body, the process consumes less energy than a similar process conducted without the body.

The oxygen content of the silicon rod drawn by means of the method according to the invention is from

0063837

30 to 40% higher than in the case in which no quartz body is used, and over the greater part of the rod is more than $10^{18}$ atoms per $cm^3$.

The silicon rod is sawn into slices in any conventional manner, from which slices semiconductor devices such as diodes, transistors and integrated circuits are made. The occurring oxygen precipitation causes good intrinsic gettering.

The invention is not restricted to the example described. It will be obvious from the above that many variations are available to those skilled in the art without departing from the scope of this invention.

0063837

1. A method of drawing a monocrystalline silicon rod from a silicon melt present in a quartz crucible, characterized in that the silicon rod is drawn through an aperture in a body floating on the melt, the aperture being chosen to be so large with respect to the diameter of the silicon rod that the shape of the meniscus of the melt around the rod is not influenced by the body.

2. A method as claimed in Claim 1, characterized in that the body consists of quartz.

3. A method as claimed in Claim 1 or 2, characterized in that the body is a flat annulus.

4. A method as claimed in Claim 3, characterized in that the floating body has pins extending beyond the circumference of the body and which keep the floating body free from the wall of the quartz crucible.

5. A semiconductor device manufactured from a silicon rod drawn by means of a method as claimed in any of the preceding Claims.

0063837

PHN 10024

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| Y | GB-A- 996 008 (MULLARD) *Claims 1,3,4; figures 1 and 2* | 1-5 | C 30 B  15/04 C 30 B  15/20 C 30 B  29/06 |
| Y | GB-A- 921 037 (GENERAL ELECTRIC) *Claims 1 and 2* | 1,2 | |
| A | FR-A-2 312 816 (IBM) | | |

TECHNICAL FIELDS SEARCHED (Int. Cl. 3)

C 30 B  15/04
C 30 B  15/10
C 30 B  29/06
C 30 B  15/20
C 30 B  15/12

The present search report has been drawn up for all claims

| Place of search THE HAGUE | Date of completion of the search 07-07-1982 | Examiner BRACKE P.P.J.L. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82